# EUROPÄISCHE PATENTANMELDUNG

(11) **EP 0 610 771 A1**
(43) Veröffentlichungstag der Anmeldung: **17.08.1994**
(21) Anmeldenummer: 94101404.5
(22) Anmeldetag: 31.01.1994
(51) Int. Cl.: H01L 27/118

(54) **Halbleiteranordnung mit CMOS-Grundzellen**

(30) Priorität: 11.02.1993 DE 4304122
(71) Anmelder: SIEMENS AKTIENGESELLSCHAFT, D-80333 München (DE)
(72) Erfinder: Keitel-Schulz, Doris, Dipl.-Ing., D-81739 München (DE)

(57) **Zusammenfassung**

Eine Grundzelle (1) für ein CMOS-Gate-Array enthält MOS-Transistoren (2, ..., 9), deren Diffusionsgebiete und Gate-Elektroden mit lokalen Leiterbahnabschnitten (30, ..., 36) unmittelbar verbindbar sind. Die lokalen Leiterbahnabschnitte sind vorzugsweise aus Silizid. Paarweise angeordnete Transistoren jeweils eines Leitfähigkeitstyps (2, 4) weisen vorzugsweise ein gemeinsames Diffusionsgebiet (12) auf, dessen kapazitiv wirksame Fläche doppelt so groß ist wie die Fläche eines einzelnen Diffusionsgebietes (10, 14). Durch Anordnung eines weiteren Transistors (18, 19) mit kleinerem Längen-zu-Seiten-Verhältnis in der Grundzelle (1) können Analog- und Speicherschaltungen flächengünstig realisiert werden.

## Beschreibung

Die Erfindung betrifft eine Halbleiteranordnung mit den Merkmalen:
(a) eine Vielzahl von Grundzellen ist in einer Zeilen- und einer Spaltenrichtung auf einem Halbleitersubstrat angeordnet,
(b) jede der Grundzellen enthält mindestens einen ersten N- und mindestens einen ersten P-Kanal-Transistor,
(c) die Transistoren weisen je eine bandartige Gate-Elektrode auf,
(d) auf beiden Seiten jeder bandartigen Gate-Elektrode ist ein Diffusionsgebiet angeordnet,
(e) jede Gate-Elektrode weist an den Enden je einen Anschlußbereich auf, der in Spaltenrichtung außerhalb der Diffusionsgebiete liegt,
(f) die N- und P-Kanal-Transistoren sind in Spaltenrichtung nebeneinander angeordnet.

Bei der aus der europäischen Offenlegungsschrift EP 0 182 121 bekannten Halbleiteranordnung sind die Diffusionsgebiete und die Gate-Elektroden der Transistoren über Metalleiterbahnen miteinander verbindbar. Die Leiterbahnen und Transistoren sind durch eine durchgehende Oxidschicht elektrisch voneinander getrennt. Üblicherweise sind mehrere Verdrahtungsebenen vorhanden, die durch weitere Oxidschichten gegeneinander isoliert sind. Die Leiterbahnen einer Verdrahtungsebene verlaufen jeweils in nur eine Richtung. Die Leiterbahnen einer ersten Verdrahtungsebene sind beispielsweise längs einer ersten Richtung, die Leiterbahnen einer zweiten Verdrahtungsebene in eine zweite, zur ersten senkrechten Richtung orientiert, die Leiterbahnen einer dritten Verdrahtungsebene in die erste oder zweite Richtung. Eine Verbindung zwischen zwei Flächenzonen der Halbleiteranordnung setzt sich somit im allgemeinen aus zueinander senkrecht verlaufenden, zu verschiedenen Verdrahtungsebenen gehörenden metallischen Leiterbahnabschnitten zusammen.

Für die Verbindung der Leiterbahnen mit den Diffusionsgebieten und Gate-Elektroden der Transistoren sowie die Verbindung der Leiterbahnen verschiedener Verdrahtungsebenen sind Kontaktlöcher durch die jeweilige Oxidschicht vorgesehen. Unmittelbar benachbarte Kontaktlöcher müssen einen technologisch vorgegebenen Mindestabstand voneinander haben. Deshalb ist eine Matrix aus Punkten festgelegt, an denen Kontaktlöcher angebracht werden können. Die Diffusionsgebiete sind deshalb derart angeordnet, daß auf ihnen mindestens eine Reihe der Punktmatrix liegt und ein Kontaktloch vollständig aufgenommen wird. Die Gate-Elektroden haben an den Enden jeweils einen verbreiterten Anschlußbereich zur Aufnahme eines Kontaktloches.

Da die Kontaktierung der Gate-Elektroden und der Diffusionsgebiete nur an den dafür vorgesehenen Punkten der Matrix möglich ist und die Verbindungsleitungen je einer Verdrahtungsebene nur längs einer Richtung verlaufen können, ist es relativ aufwendig, kreuzungsfreie Verbindungen der Transistoren untereinander herzustellen.

Die Aufgabe der Erfindung ist es, eine Halbleiteranordnung mit Grundzellen der beschriebenen Art anzugeben, deren Verdrahtung flexibel und platzsparend möglich ist.

Diese Aufgabe wird durch mindestens einen lokalen Leiterbahnabschnitt gelöst, der mit einem der Anschlußbereiche der Gate-Elektroden oder einem der Diffusionsgebiete ohne dazwischen liegende Oxidschicht verbunden ist.

Eine erfindungsgemäße Halbleiteranordnung hat den Vorteil, daß für lokal begrenzte Verbindungen weder Kontaktierungslöcher noch eine metallische Verdrahtungslage benötigt werden. Die lokalen Leiterbahnabschnitte können sowohl in Spalten- als auch in Zeilenrichtung orientiert werden. Die Verdrahtungsflexibilität wird dadurch erhöht. Der Platzbedarf wird verringert.

Wenn die Anschlußbereiche der Gate-Elektroden mit der Spaltenrichtung einen Winkel einschließen, wird ein Wechsel zwischen zwei benachbarten Spalten der Matrix der Kontaktierungslöcher ohne Verwendung einer der Metallisierungsebenen möglich.

Bei einer Grundzelle, die mindestens ein N-Kanal- und ein P-Kanal-Transistorpaar enthält, bei denen jeweils ein Diffisions der beiden Transistoren eines Transistorpaares ein gemeinsames Diffusionsgebiet bilden, kann die Fläche des gemeinsamen Diffusionsgebietes doppelt so groß gewählt werden wie die Fläche eines einzelnen Diffusionsgebietes. Werden bei der Realisierung einer Schaltung zwei einzelne Diffusionsgebiete miteinander verbunden, verhalten sich diese elektrisch gleich wie ein gemeinsames Diffusionsgebiet, da die kapazitiven Lasten jeweils gleich sind. Zur Kontaktierung von zwei einzelnen benachbarten Diffusionsgebieten mit einer der Metallisierungsebenen wird nur eine Spalte der Matrix der Kontaktierungslöcher verwendet. Diese Spalte der Matrix ist zwischen den zwei einzelnen Diffusionsgebieten angeordnet. Dadurch können die einzelnen Diffusionsgebiete klein dimensioniert werden.

Es ist vorteilhaft, je einen weiteren Transistor mit einem kleineren Längen-zu-Seiten-Verhältnis neben den N- und P-Kanal-Transistorpaaren in die Grundzelle aufzunehmen, so daß analoge Schaltungsfunktionen erzeugt werden können. Die weiteren Transistoren können auch bei der Realisierung von statischen Speicherzellen als Auswahltransistoren zur Verbindung einer Datenleitung mit einer der Speicherzellen verwendet werden. Dadurch sind Speicherzellen mit geringem Flächenverbrauch realisierbar.

Die lokalen Leiterbahnabschnitte werden vorzugsweise aus Silizid hergestellt. Dies hat den Vorteil einer widerstandsarmen elektrischen Verbindung der lokalen Leiterbahnabschnitte mit den Gate-Elektroden und den Diffusionsgebieten.

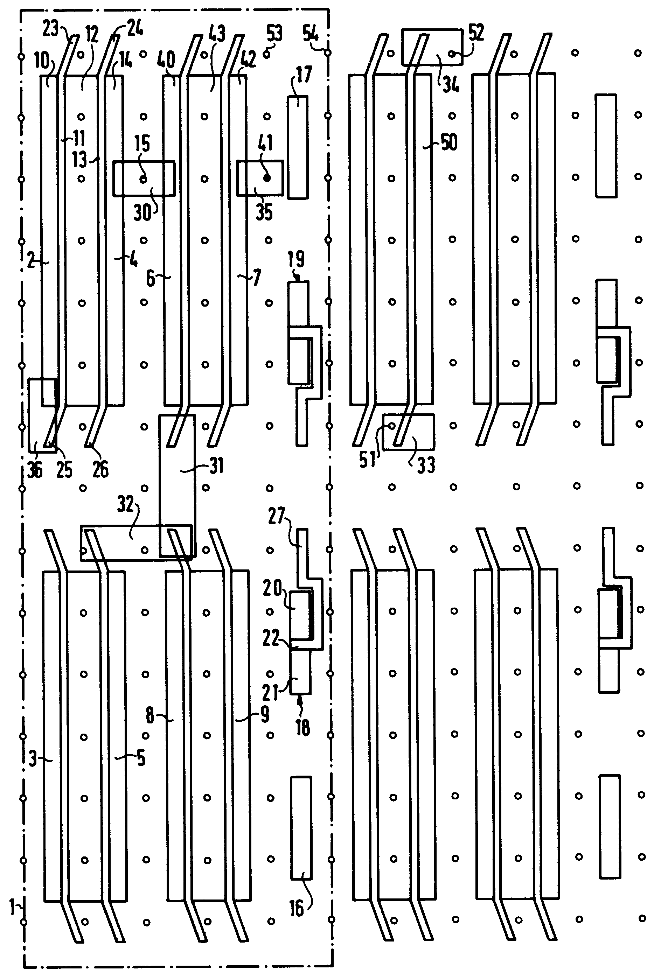

Die Erfindung wird im folgenden anhand der in der Zeichnung dargestellten Figur näher erläutert.

Dort ist eine erfindungsgemäße Halbleiteranordnung mit mölichen Ausführungsformen dargestellt. Eine solche Halbleiteranordnung wird üblicherweise als Gate-Array oder Masterslice bezeichnet. Die Anordnung enthält eine Vielzahl von Grundzellen 1, von denen exemplarisch zwei Grundzellen dargestellt sind. Die Grundzellen sind regelmäßig in Zeilen- und Spaltenrichtung angeordnet. Die Grundzellen können unmittelbar oder mit einem Zwischenraum versehen nebeneinander angeordnet sein. Metallische Leiterbahnen, die zur Verdrahtung der Grundzellen verwendet werden, verlaufen durch eine Oxidschicht von den Transistoren der Anordnung getrennt im ersten Fall über den Grundzellen, im zweiten Fall innerhalb der als Verdrahtungskanäle dienenden Zwischenräume.

Die Grundzelle 1 enthält eine Anordnung aus acht MOS-Transistoren 2, ..., 9. Die Transistoren 2, 4, 6, 7 sind H-Kanal-Transistoren, die Transistoren 3, 5, 8, 9 P-Kanal-Transistoren. Der MOS-Transistor 2 besteht aus den Diffusionsgebieten 10, 12 und einer dazwischen angeordneten Gate-Elektrode 11. In entsprechender Weise ist der MOS-Transistor 4 aus den Diffusionsgebieten 12, 14 und Gate-Elektrode 13 aufgebaut. Die Transistoren 2, 4 weisen ein gemeinsames Diffusionsgebiet 12 auf. Die anderen Transistoren sind in entsprechender Weise aufgebaut. Das Transistorpaar 6, 7 ist in Zeilenrichtung neben dem Transistorpaar 2, 4 angeordnet. Die Transistorpaare 3, 5 bzw. 8, 9 liegen in Spaltenrichtung neben den Transistorpaaren 2, 4 bzw. 6, 7. Zum Anschluß der Substratbereiche der N-Kanal- bzw. P-Kanal-Transistoren der Grundzelle 1 sind je ein Anschlußbereich 17 bzw. 16 vorgesehen. In Spaltenrichtung neben den Substratanschlüssen 16, 17 ist jeweils ein weiterer N-Kanal- bzw. P-Kanal-Transistor 18 bzw. 19 angeordnet. Der Transistor 18 weist Diffusionsgebiete 20, 21 und eine Gate-Elektrode 22 auf. Das Längen-zu-Seiten-Verhältnis der Transitoren 18, 19 ist kleiner als das Längen-zu-Seiten-Verhältnis der Transitoren 2, ..., 9.

Die Gate-Elektrode jedes Transistors weist zwei Anschlußbereiche auf, die den Bereich der Diffusionsgebiete überragen. So weisen die Gate-Elektroden der Transistoren 2, 4 an einem Ende die Anschlußbereiche 23, 24, am anderen Ende die Anschlußbereiche 25, 26 auf. Die die Diffusionsgebiete beeinflussenden Abschnitte der Gate-Elektroden verlaufen in Spaltenrichtung. Die Anschlußbereiche 23, ..., 26 der Gate-Elektroden sind in einem spitzen Winkel zur Spaltenrichtung orientiert. Dabei sind der Winkel der Abschnitte 23, 24 auf der einen Seite der Diffusionsgebiete und der Winkel der Abschnitte 25, 26 auf der anderen Seite der Diffusionsgebiete eines Transistors zueinander gegensinnig orientiert. Das heißt, daß in der Zeichnung die Enden der Anschlußgebiete 23, 24 nach rechts und die Enden der Anschlußgebiete 25, 26 nach links weisen. Die Gate-Elektrode 22 des Transistors 18 ist mit einem Anschlußbereich 27 verbunden. Der Anschlußbereich 27 ist längs der Spaltenrichtung orientiert. Es ist auch möglich, daß dieser Anschlußbereich einen Winkel zur Spaltenrichtung bildet.

Gemäß einer zu realisierenden Schaltung werden die auf dem Masterslice vorhandenen Diffusionsgebiete, Gate-Elektroden und Substratanschlüsse miteinander verdrahtet. Für kurze Verbindungen sind lokale Abschnitte von Verbindungsleiterbahnen vorgesehen, die mit den Anschlußbereichen der Gate-Anschlüsse und den Diffusionsgebieten unmittelbar verbindbar sind. Unmittelbar bedeutet, daß die Leiterbahnabschnitte nicht durch eine Oxidschicht isoliert sind. Es sind dann auch keine Kontaktlöcher notwendig. Außerhalb der Diffusionsgebiete und der Gate-Anschlüsse der Transistoren werden die lokalen Leiterbahnabschnitte über das Feldoxid geführt. Eine Auswahl von möglichen lokalen Verbindungen sind mit den Bezugszeichen 30, ..., 36 bezeichnet in der Figur dargestellt. Die lokalen Verbindungsleiterbahnen sind vorteilhafterweise aus Silizid hergestellt. Als Silizidverbindungen eignen sich besonders Titan-, Molybdän- oder Wolframsilizide. Diese Materialien können unmittelbar, also ohne dazwischen liegende Oxidschicht, beispielsweise durch Sputtern und anschließendes Ätzen, auf die zu verbindenden Anschlußbereiche aufgebracht werden. Die lokalen Verbindungsleiterbahnen werden nur für kurze Verbindungsstrecken verwendet, wie beispielsweise zur Verbindung der Anschlüsse von nebeneinander liegenden Transistoren oder zur Verbindung der Gate-Elektroden bzw. Diffusionsgebiete eines Transistors mit einem Kontaktloch. Über das Kontaktloch ist dann die Verbindung zu einer metallischen Leiterbahn möglich. Die Kontaktlöcher müssen bedingt durch die minimalen herstellbaren Strukturbreiten des Herstellungsprozesses gewisse Mindestabstände zueinander einhalten. Die Matrix der Kontaktierungslöcher, der beispielsweise die Kontakte 15, 41, 52 angehören, ist in der Figur dargestellt. Die lokalen Verbindungsleiterbahnen können sowohl längs der Spalten- als auch der Zeilenrichtung verlaufen.

Der lokale Leiterbahnsabschnitt 35 verbindet beispielsweise das Diffusionsgebiet 42 des Transistors 7 mit dem Kontaktierungsloch 41. Die Spalte der Kontaktierungsmatrix, der das Kontaktierungsloch 41 angehört, liegt außerhalb des Diffusionsgebietes 42. Dadurch ist es möglich, das Diffusionsgebiet 42 möglichst klein zu dimensionieren. Durch den lokalen Leiterbahnabschnitt 30 werden die Diffusionsgebiete 14, 40 der Transistoren 4, 6 miteinander verbunden. Über den Kontakt 15 ist eine Verbindung zu einer metallischen Verdrahtungsebene möglich. Die Spalte der Kontaktierungsmatrix, zu der der Kontakt 15 gehört, ist zwischen den Diffusionsgebieten 14, 40 angeordnet. Die benachbarten Spalten der Kontaktierungsmatrix liegen in den gemeinsamen Diffusionsgebieten 12 bzw. 43. Es ist vorteilhaft, die Fläche der Diffusionsgebiete derart zu dimensionieren, daß die Summe der Flächen der Diffusionsgebiete 14, 40 gleich ist der Fläche des gemeinsamen Diffusionsgebietes 12 bzw. 43. Die Substratkapazität der miteinander verbundenen Diffusionsgebiete 14, 40 ist dann gleich der Kapazität eines der gemeinsamen Diffusionsgebiete 12 bzw. 43. Somit ist gewährleistet, daß sich zwei miteinander verbundene einzelne Diffusionsgebiete elektrisch gleich einem gemeinsamen Diffusionsgebiet verhalten.

Die Einstellung dieses Flächenverhältnisses von gemeinsamen und einzelnen Diffusionsgebieten ist dadurch möglich, daß Metallkontakte von einzelnen Diffusionsgebieten über lokale Leiterbahnabschnitte hergestellt werden und sich deshalb für die Fläche der Diffusionsgebiete keine weitere Einschränkung ergibt.

Das lokale Verbindungsstück 31 ist längs der Spaltenrichtung, das lokale Verbindungsstück 32 längs der Zeilenrichtung orientiert. Dadurch ist es möglich, die Gate-Anschlüsse zweier benachbarter Transistoren ohne Verwendung der metallischen Verdrahtungsebene zu verbinden. Das lokale Verbindungsstück 36 verbindet das Diffusionsgebiet 10 mit der Gate-Elektrode 11 des gleichen Transistors. Die lokalen Verbindungsstücke 33, 34 sind mit den beiden Anschlußbereichen der Gate-Elektrode eines MOS-Transistors 50 verbunden. Der Leiterbahnabschnitt 33 enthält einen Kontakt 51 einer ersten Spalte der Kontaktierungsmatrix, der lokale Leiterbahnabschnitt 34 einen Kontakt 52 einer zweiten, dazu benachbarten Spalte der Kontaktierungsmatrix. Mittels der lokalen Verbindungsstücke 33, 34 ist es somit möglich, ohne Zugriff auf eine metallische Verbindungsebene von einer Reihe der Verbindungsmatrix auf die benachbarte Reihe zu wechseln. Durch diese Flexibilität der lokalen Verbindungsstücke werden für derartige beispielhaft beschriebene Möglichkeiten einer lokalen elektrischen Verbindung der Diffusionsgebiete und Gate-Elektroden der MOS-Transistoren der Halbleiteranordnung untereinander keine metallischen Leiterbahnen verwendet. Die metallischen Verdrahtungsebenen bleiben dann für längere, niederohmige Verbindungen frei. Die Verbindungsflexibilität innerhalb einer Grundzelle bzw. zwischen den Anschlüssen benachbarter Transistoren verschiedener Grundzellen sowie die Verbindung zwischen weit auseinanderliegenden Punkten der Halbleiteranordnung wird gegenüber dem Stand der Technik erhöht.

Durch die lokalen Verbindungsstücke sind auch die Transistoren 18, 19 mit einem geringeren Längen-zu-Seiten-Verhältnis verbindbar. Diese Transistoren können verwendet werden, um Pegel zu erzeugen, die zwischen den Werten der Versorgungspotentiale liegen. Somit sind analoge Funktionen in eingeschränktem Umfang möglich. Mit den acht Transistoren der Grunsdzelle 1 ist es möglich, zwei Speicherzellen mit jeweils vier Transistoren zu realisieren. Die Transistoren 18, 19 können dann vorteilhafterweise als Auswahltransistoren verwendet werden, um je eine Speicherzelle an eine Datenleitung anzuschließen. Die Transistoren 18, 19 können sowohl über die Spalte 54 als auch über die Spalte 53 der Kontaktlochmatrix kontaktiert werden. Sie können also innerhalb der Grundzelle 1 oder zu der ihr benachbarten Grundzelle hin lokal verbunden werden. Dies hat den Vorteil, daß eine hohe Verdrahtungsflexibilität zur Erzeugung einer Schaltung mittels der Halbleiteranordnung gewährleistet ist.

In dem in der Figur gezeigten Ausführungsbeispiel ist eine Grundzelle mit acht MOS-Transistoren 2, ..., 9 mit einem ersten Längen-zu-Seiten-Verhältnis und zwei MOS-Transitoren 18, 19 mit einem kleineren zweiten Längen-zu-Seiten-Verhältnis gezeigt. Es sind weitere Ausführungsformen einer erfindungsgemäßen Halbleiteranordnung möglich, bei denen beispielsweise die Grundzellen 2 oder 4 MOS-Transistoren der ersten Ausführung enthalten. Eine Hälfte der Transistoren ist jeweils vom N-Kanal-Typ, die andere Hälfte vom P-Kanal-Typ. Bei einer Grundzelle mit vier MOS-Transistoren der ersten Ausführung können die Transistoren entweder als einzelne Transistoren oder jeweils paarweise als Transistoren mit einem gemeinsamen Diffusionsgebiet angeordnet sein.

Eine Anordnung mit vier oder acht MOS-Transistoren der ersten Ausführung eignet sich besonders zur flächengünstigen Realisierung von statischen Vier-Transistor-Speicherzellen.

## Patentansprüche

1. Halbleiteranordnung mit den Merkmalen:
(a) eine Vielzahl von Grundzellen (1) ist in einer Zeilen- und einer Spaltenrichtung auf einem Halbleitersubstrat angeordnet,
(b) jede der Grundzellen (1) enthält mindestens einen ersten N- und mindestens einen ersten P-Kanal-Transistor (2, 3),
(c) die Transistoren (2, 3) weisen je eine bandartige Gate-Elektrode (11) auf,
(d) auf beiden Seiten jeder bandartigen Gate-Elektrode (11) ist je ein Diffusionsgebiet (10, 12) angeordnet,
(e) jede Gate-Elektrode (11) weist an den Enden je einen Anschlußbereich (23, 25) auf, der in Spaltenrichtung außerhalb der Diffusionsgebiete (10, 12) liegt,
(f) die N- und P-Kanal-Transistoren (2, 3) sind in Spaltenrichtung nebeneinander angeordnet,
**gekennzeichnet durch** mindestens einen lokalen Leiterbahnabschnitt (31, ..., 36), der mit einem der Anschlußbereiche der Gate-Elektroden oder einem der Diffusionsgebiete ohne dazwischen liegende Oxidschicht verbunden ist.

2. Halbleiteranordnung nach Anspruch 1, **dadurch gekennzeichnet**, daß die Anschlußbereiche jeder Gate-Elektrode jeweils in einem spitzen Winkel zur Spaltenrichtung verlaufen und daß der Winkel des Anschlußbereichs an einem ersten Ende der Gate-Elektrode zu dem Winkel des Anschlußbereichs an einem zweiten Ende der Gate-Elektrode gegensinnig orientiert ist.

3. Halbleiteranordnung nach Anspruch 1 oder 2, **dadurch gekennzeichnet**, daß jede Grundzelle mindestens ein N-Kanal-Transistorpaar und mindestens ein P-Kanal-Transistorpaar enthält und daß die Transistorpaare jeweils in Zeilenrichtung nebeneinander angeordnet sind und daß benachbarte Diffusionsgebiete der Transistoren jeweils eines Paares ein gemeinsames Diffusionsgebiet bilden.

4. Halbleiteranordnung nach Anspruch 3, **dadurch gekennzeichnet**, daß die kapazitiv wirksame Fläche der gemeinsamen Diffusionsgebiete doppelt so groß ist wie die Fläche eines einzelnen Diffusionsgebietes.

5. Halbleiteranordnung nach Anspruch 3 oder 4, **dadurch gekennzeichnet**, daß eine Matrix aus möglichen Kontaktierungslöchern festgelegt ist, durch die eine metallische, über eine Oxidschicht verlaufende Leiterbahn mit den lokalen Leiterbahnabschnitten oder den gemeinsamen Diffusionsgebieten verbindbar ist, und daß die Diffusionsgebiete längs der Zeilenrichtung derart ausgedehnt sind, daß eine Spalte der Matrix über den gemeinsamen Diffusionsgebieten und eine unmittelbar benachbarte Spalte der Matrix außerhalb der Diffusionsgebiete liegt.

6. Halbleiteranordnung nach Anspruch 3 oder 4, **dadurch gekennzeichnet**, daß in jeder Grundzelle jeweils in Zeilenrichtung neben dem N-Kanal-Transistorpaar und neben dem P-Kanal-Transistorpaar ein weiterer Transistor und einen Substratanschluß angeordnet ist und daß die Gate-Elektrode des weiteren Transistors ein kleineres Seiten-zu-Längen-Verhältnis hat als die Gate-Elektroden der Transistoren des N- und P-Kanal-Transistorpaares.

7. Halbleiteranordnung nach Anspruch 6, **dadurch gekennzeichnet**, daß die Gate-Elektrode jedes weiteren Transistors in einem ersten Abschnitt längs der Zeilenrichtung orientiert ist, daß auf beiden Seiten des ersten Abschnitts je ein Diffusionsgebiet angeordnet ist und daß die Gate-Elektrode in einem zweiten Abschnitt einen Anschlußbereich hat, der in Zeilenrichtung neben den Anschlußbereichen der Transistoren des N- und P-Kanal-Transistorpaares angeordnet ist.

8. Halbleiteranordnung nach einem der Ansprüche 1 bis 7, **dadurch gekennzeichnet**, daß der lokale Leiterbahnabschnitt (31, ..., 36) aus Silizid ist.
